# EUROPÄISCHE PATENTSCHRIFT

(11) **EP 2 272 112 B1**
(45) Veröffentlichungstag und Bekanntmachung des Hinweises auf die Patenterteilung: **15.06.2016**
(21) Anmeldenummer: 09726719.9
(22) Anmeldetag: 14.03.2009
(51) Int. Cl.: H01L 39/24

(54) **HOCHTEMPERATURSUPRALEITER-SCHICHTANORDNUNG**
HIGH-TEMPERATURE SUPERCONDUCTIVE LAYER ARRANGEMENT
ENSEMBLE DE COUCHES DE SUPRACONDUCTEUR À HAUTE TEMPÉRATURE

(30) Priorität: 29.03.2008 DE 102008016258
(43) Veröffentlichungstag der Anmeldung: 12.01.2011
(73) Patentinhaber: BASF SE, 67056 Ludwigshafen am Rhein (DE)
(72) Erfinder: BÄCKER, Michael, 50670 Köln (DE); BRUNKAHL, Oliver, 53424 Remagen (DE); FALTER, Martina, 53359 Swisstal-Buschhoven (DE)
(74) Vertreter: BASF IP Association
(86) Internationale Anmeldenummer: PCT/DE2009/000357
(87) Internationale Veröffentlichungsnummer: WO 2009/121321

(56) Entgegenhaltungen:
- EP-A- 1 195 819
- WO-A-00/16412
- WO-A-03/044836
- WO-A-2006/082164
- DE-A1-102004 038 030
- AYALA A ET AL: "Synthesis and Characterization of Cu-Doped SrTiO3 Powders and Sol-Gel Processed Buffer Layers on IBAD MgO Templates" IEEE TRANSACTIONS ON APPLIED SUPERCONDUCTIVITY, IEEE SERVICE CENTER, LOS ALAMITOS, CA, US, Bd. 15, Nr. 2, 1. Juni 2005 (2005-06-01), Seiten 2703-2706, XP011134237 ISSN: 1051-8223
- CHAMBONNET D ET AL: "Control of the 2D/3D transition of the growth mechanism in the YBCO/Ce1-xLaxO2-x/2/SrTiO3 system" PHYSICA C, NORTH-HOLLAND PUBLISHING, AMSTERDAM, NL, Bd. 302, Nr. 2-3, 1. Juni 1998 (1998-06-01), Seiten 198-206, XP004149175 ISSN: 0921-4534
- MUKOVOZOV I E ET AL: "Structural effects of interaction between lanthanum cuprate and cerium dioxide" JOURNAL OF MATERIALS SCIENCE CHAPMAN & HALL UK,, Bd. 32, Nr. 18, 15. September 1997 (1997-09-15), Seiten 4991-4997, XP002536246
- LV ET AL: "Synthesis and electrochemical behavior of Ce1-xFexO2-delta as a possible SOFC anode materials" SOLID STATE IONICS, NORTH HOLLAND PUB. COMPANY. AMSTERDAM, NL, Bd. 177, Nr. 39-40, 23. Dezember 2006 (2006-12-23), Seiten 3467-3472, XP005734771 ISSN: 0167-2738
- JINGKUI LIANG ET AL: "Phase diagram of SrO-CaO-CuO ternary system" SOLID STATE COMMUNICATIONS, OXFORD, Bd. 75, Nr. 3, 1. Juli 1990 (1990-07-01), Seiten 247-252, XP024572236 ISSN: 0038-1098 [gefunden am 1990-07-01]

## Beschreibung

Die Erfindung betrifft eine Hochtemperatursupraleiter-Schichtanordnung umfassend mindestens ein Trägermaterial und eine texturierte Pufferschicht, die ein texturiertes Aufwachsen einer Hochtemperatursupraleiter(HTSL)-Schicht ermöglicht, nach dem Oberbegriff von Anspruch 1.

Die Pufferschicht hat eine Vielzahl unterschiedlicher Funktionen. Zum einen soll diese die Textur von dem einen möglichst hohen Texturgrad aufweisenden texturierten Trägermaterial möglichst vollständig und perfekt auf die aufzuwachsende HTSL-Schicht übertragen. Hierbei ist zu berücksichtigen, dass das Trägermaterial möglichst weitgehend biaxial texturiert ist, d.h. sowohl senkrecht zu der Schicht als auch in einer axialen Richtung innerhalb der Schicht. Eine entsprechende biaxiale Texturierung des Hochtemperatursupraleiters ist zur Erzielung hoher kritischer Ströme und hoher Stromdichten notwendig. Weiterhin soll die Pufferschicht eine Diffusion von Bestandteilen oder Verunreinigungen des Trägermaterials in die HTSL-Schicht verhindern, da hierdurch die kritische Stromdichte und/oder der absolute kritische Strom des Hochtemperatursupraleiters vermindert oder der supraleitende Zustand gestört werden kann. Weiterhin soll die Pufferschicht eine möglichst hohe Haftfestigkeit sowohl mit dem Trägermaterial als auch mit dem aufzuwachsenden Hochtemperatursupraleiter aufweisen. Weiterhin muss die Pufferschicht ausreichende mechanische und Temperaturwechseleigenschaften aufweisen, sowohl unter Berücksichtigung der Herstellungs- als auch der Einsatzbedingungen. Zudem soll die Pufferschicht möglichst einfach, reproduzierbar und mit hoher Prozessgeschwindigkeit herstellbar sein.

Als Pufferschichtmaterial werden bisher eine Reihe unterschiedlicher Materialien eingesetzt, wie beispielsweise Yttriumstabilisiertes Zirkonoxid (YSZ), verschiedene Zirkonate wie Gadoliniumzirkonat, Lanthanzirkonat oder dergleichen, Titanate wie Strontiumtitanat, einfache Oxide wie Ceroxid, Magnesiumoxid oder dergleichen. Um das heutzutage bestehende komplexe und hohe Anforderungsprofil zu erfüllen, insbesondere einen hohen Texturübertrag und hohe Diffusionsbarriere zu gewährleisten, besteht die Pufferschicht aus Schichtkombinationen mehrerer unterschiedlicher Puffermaterialien, teilweise aus fünf oder mehr Schichten. Die Aufbringung mehrerer Schichten von Puffermaterial ist jedoch verfahrenstechnisch überaus aufwändig und reduziert die Produktionsgeschwindigkeit des Gesamtherstellungsverfahrens einer funktionsfähigen HTSL-Schichtanordnung beträchtlich, auch wenn beispielsweise zur Herstellung von Bändern kontinuierliche Prozesstechniken eingesetzt werden. Durch die Verwendung einer einschichtigen Pufferschicht herkömmlicher Materialien kann das komplexe Anforderungsprofil jedoch nur unzulänglich erfüllt werden.

Weiterhin besteht ein Bedürfnis, die Qualität der Hochtemperatursupraleiter-Schichten im Hinblick auf deren Homogenität und Textur weiter zu erhöhen. So soll der Anteil an Bereichen der HTSL-Schicht, die nicht HTSL-Material aufweisen, z.B. aufgrund einer Porosität der HTSL-Schicht oder aufgrund von Fremdphasen, möglichst minimal sein. Ferner sollen Bereiche mit Fehltexturierungen, die nicht nur eine Verkippung gegenüber der Vorzugsorientierung sondern Bereiche mit völlig verschiedener Kristallorientierung darstellen können, vermieden werden. Diese Eigenschaften der HTSL-Schicht können teilweise durch die Wahl der Precursor der HTSL-Materialien bei chemischen Abscheidungsverfahren und die Parameter der Abscheidungs- und Glühprozesse beeinflusst werden, die Effekte sind jedoch nur schwer vorhersagbar und teilweise gegenläufig. Aufgrund der Mehrkomponentensysteme der HTSL-Materialien ist die Kinetik der Zersetzung der Precursoren und Kristallisation des HTSL-Materials oftmals auch nur schwierig steuerbar, so dass Veränderungen der Prozessparameter oftmals nicht erwünscht sind.

Diese Anforderungen sollen nach Möglichkeit insbesondere bei einer HTSL-Schichtanordnung erfüllt werden, bei welcher die Pufferschicht und/oder die HTSL-Schicht mittels chemischer Lösungsbeschichtungen herstellbar sind. Aufgrund der hiermit verbundenen Vorgänge bei thermischer Bildung der Puffer- und HTSL-Schicht sind auch an die Erzeugung dieser Schichten besondere Anforderungen zu stellen. Insbesondere unterscheidet sich die Kinetik der Schichtbildung und Kristallisation grundlegend von den Erfordernissen an eine Erzeugung dieser Schichten durch physikalische Verfahren wie Pulsed-Laser-Deposition (PLD), thermische Coverdampfung (TCE), metallorganischer Gasphasenabscheidung (MOCVD) oder dergleichen.

Die WO 03/044836 A2 beschreibt eine Hochtemperatursupraleiter-Schichtanordnung umfassend ein Substrat und eine Zwischenschicht, wobei die Zwischenschicht unter Verwendung eines Targets hergestellt ist und das Target eine innige Mischung aus MgO und CuO ist.

Ayala et.al. "Synthesis and Characterization of Cu-doped SrTiO3 Powders and Sol-Gel Processed Buffer Layers on IBAD MgO Templates"; IEEE Transactions on Applied Superconductivity, Bd. 15, Nr. 2, 1. Juni 2005, Seiten 2703-2706, beschreibt die Herstellung von Cu-dotiertem SrTiO3 Pulvern und die Abscheidung von Pufferschichten auf IBAD MgO Templaten.

Die EP 1195819 A beschreibt eine Hochtemperatursupraleiter-Schichtanordnung umfassend ein metallisches Substrat und wenigstens eine Pufferschicht basierend auf dotiertem Cerdioxid, sowie weitere Zwischenschichten, welche durch PLD- oder IBAD-Verfahren hergestellt sind.

Die WO 2006/082164 A1 beschreibt eine gattungsgemäße Schichtanordnung mit einem metallischen Trägermaterial mit einer texturierten Oberfläche und mit einer Ceroxide enthaltenden Pufferschicht, wobei die Pufferschicht mit Kationen dotiert ist und durch chemische Lösungsbeschichtng erzeugt sein kann.

Der Erfindung liegt hiermit die Aufgabe zugrunde, eine Hochtemperatursupraleiter-Schichtanordnung bereitzustellen, die eine dichte, homogene, rissfreie und möglichst glatte HTSL-Schicht aufweist oder bei welcher eine derartige HTSL-Schicht durch Aufwachsen auf die Pufferschicht erzeugbar ist, wobei die Schichten vorzugsweise durch chemische Lösungsbeschichtungen herstellbar sind. Ferner besteht die Aufgabe darin, ein Verfahren zur Herstellung derartiger Schichtanordnungen bereitzustellen.

Diese Aufgabe wird durch die HTSL-Schichtanordnung nach Anspruch 1 und ein Verfahren nach Anspruch 10 gelöst.

Erfindungsgemäß wird als weiterer Bestandteil der Pufferschicht ein Übergangsmetall der ersten Nebengruppe, nämlich Kupfer und/oder Silber, eingesetzt, (einschließlich in Form eines Oxids), wobei der weitere Bestandteil in einem Gehalt von 2 bis zu 40 at.-% bezogen auf den Gesamtmetallgehalt der Pufferschicht vorliegt.
Durch den weiteren erfindungsgemäßen Bestandteil, der mit dem Pufferschichtmaterial eine homogene Mischkristallphase bildet, kann überraschenderweise eine Pufferschicht erzeugt werden, die eine sehr geringe oder praktisch keine Porosität und zudem eine nur sehr geringe Rauheit aufweist und die mit hoher Dichtigkeit und praktisch rissfrei herstellbar ist. Weiterhin ist eine derartige Pufferschicht durch chemische Lösungsbeschichtung (CSD) herstellbar.

Durch den weiteren Bestandteil, der mit dem Pufferschichtmaterial eine homogene, feste Mischkristallphase bildet, kann bei der Erzeugung der Pufferschicht zumindest eine partielle Schmelze gebildet werden, so dass bei der anschließenden Glühbehandlung eine zumindest partielle Rekristallisation des Pufferschichtmaterials erfolgen kann, wobei zumindest bereichsweise intermediär eine Flüssigphase entsteht. Hierbei wird ermöglicht, dass die Textur des Trägermaterials wesentlich besser als bei Verwendung des Pufferschichtmaterials ohne den weiteren Bestandteil auf die Pufferschicht und damit letztendlich auf die HTSL-Schicht übertragen wird und zudem eine Pufferschicht mit deutlich verminderter oder praktisch ohne Porosität und Mikrorissen erzeugt wird, die zudem wesentlich glatter als herkömmliche Schichten ist. Der weitere Bestandteil kann hierbei ein Metall und/oder Metalloxid sein, und/oder jeweils ein Precursor desselben sein, welcher bei der zumindest eine partielle Schmelze bildenden Glühtemperatur ein derartiges Metall oder Oxid freisetzt, wie beispielsweise ein Hydroxid, Carbonat, Nitrat, Citrat, Alkylcarboxylat, Acetylacetonat oder ein anderes geeignetes Metallchelat, oder dergleichen, einschließlich Mischungen derselben.

Durch die erfindungsgemäße Pufferschicht kann die auf diese aufwachsende HTSL-Schicht ebenfalls sehr homogen, d.h. praktisch ohne Poren oder sonstige Bereiche, die wie z.B. Mikrorisse einen supraleitenden Stromdurchgang behindern, erzeugt werden, wobei zudem die HTSL-Schicht besonders glatt herstellbar ist. Gegebenenfalls kann auch der Texturübertrag verbessert werden. Insbesondere werden auch Aufwachsfehler auf die Pufferschicht, wie im Bereich von Poren herkömmlicher Pufferschichten vorliegen können und die zu Bereichen mit anderer Kristallorientierung führen können, drastisch vermindert. Eine derartige HTSL-Schicht weist verbesserte physikalische und mechanische Eigenschaften auf, insbesondere auch im Hinblick auf die supraleitenden Eigenschaften wie kritische Stromdichte und die absolute kritische Stromstärke I_{c}, wodurch auch elektronische HTSL-Bauteile mit verbesserten Eigenschaften herstellbar sind.

Das Ergebnis ist insoweit überraschend, als dass bei Aufbringung des Pufferschichtmaterials durch chemische Lösungsbeschichtung die Bildung der Pufferschicht eine Vielzahl komplizierter physikochemischer Vorgänge umfasst, wie Verdampfen des Lösungsmittels, Zersetzung von Pufferschichtmaterial, Bildung amorpher Festphasen des Pufferschichtmaterials, Rekristallisation desselben, wobei auch die veränderten thermischen Eigenschaften des Pufferschichtmaterials bei der komplexen Temperaturführung des Verfahrens zur Erzeugung der Pufferschicht zu berücksichtigen sind.

Bevorzugte Weiterbildungen ergeben sich aus den Unteransprüchen.

Das Trägermaterial ist biaxial texturiert, d.h. senkrecht zu der Schichtebene, auf welcher das HTSL-Materials aufgewachsen wird, und in einer Richtung innerhalb der Schichtebene, beispielsweise im Falle eines bandförmigen Trägermaterials der Bandlängsrichtung. Das Trägermaterial kann bandförmig aber auch anders dimensioniert sein, z.B. in Form von eher isometrischen Schichten. Die Pufferschicht besteht zumeist aus einem oxidkeramischen Material bzw. einem Metalloxid.

Vorzugsweise bildet der weitere, eine homogene Mischkristallphase bildende Bestandteil in Form des Übergangsmetalls der ersten Nebengruppe bei einer Glühtemperatur von ≤ 1.600 Grad Celsius mit dem oxidischen Puffermaterial zumindest eine partielle Schmelze.

Vorzugsweise bildet der weitere Bestandteil mit dem Pufferschichtmaterial bei Temperaturen im Bereich von 1600-500°C, 1400-600°C, 1250-700°C oder 1100-800°C eine nur partielle Schmelze, so dass Fest- und Flüssigphase des Pufferschichtmaterials miteinander koexistieren, oder eine praktisch homogene bzw. vollständige Schmelze. Dies gilt auch für den Fall, dass der weitere Bestandteil ein Übergangsmetall und/oder Übergangsmetalloxid ist.

Allgemein kann der weitere Bestandteil derart ausgewählt und in einem Gehalt in dem Pufferschichtmaterial vorliegen, dass dieser bei einer Glühbehandlung von ≤ 1.600°C, vorzugsweise bei ≥ 500°C, eine zumindest partielle oder vollständige Schmelze bildet. Insbesondere kann der weitere Bestandteil derart ausgewählt und in einem Gehalt in dem Pufferschichtmaterial vorliegen, dass dieses bei einer Glühbehandlung von ≤ 1.500°C oder ≤ 1.300 bis 1.400°C, vorzugsweise ≤ 1.100 bis 1.200°C oder ≤ 900 bis 1.000°C zumindest eine partielle oder vollständige Schmelze bildet. Es versteht sich, dass die Glühtemperatur derart zu wählen ist, dass das Pufferschichtmaterial keine unerwünschte Zersetzung oder Verflüchtigung von Bestandteilen erleidet und das Trägermaterial nicht beeinträchtigt wird, beispielsweise durch unerwünschte Phasenbildung oder nachteilige Veränderungen dessen Textur.

Der weitere Bestandteil kann in einer Konzentration in dem Pufferschichtmaterial eingesetzt werden, so dass dieses vorzugsweise bei der Glühbehandlung von ≤ 1500-1600°C aber auch der weiteren Abkühlung bis auf beispielsweise ≤ 800-900°C 600-700°C, ≤ 400-500°C, 200-300°C oder bis auf Raumtemperatur oder tieferen Temperaturen bis ca. 70-80 Kelvin oder tiefer keine amorphen Phasen oder keine Mischphasen z.B. durch Phasenumwandlungen entstehen und die homogene Mischkristallphase auch unterhalb der Glühtemperatur langzeitbeständig ist. Die den weiteren Bestandteil enthaltende homogene Festkörpermischkristallphase kann bei Raumtemperatur und/oder der Einsatztemperatur des HTSL-Materials kinetisch langzeitbeständig sein, vorzugsweise ist sie auch thermodynamisch in dem Temperaturbereich von der Glühbehandlung (siehe oben) bis zu der Einsatztemperatur des HTSL-Materials beständig, so dass Entmischungsvorgänge oder Phasensegregationen, Ausscheidung von amorphen Phasen oder sonstigen Phasenänderungen nicht stattfinden.

Weiterhin sollten die weiteren Bestandteile allgemein nicht eine signifikante oder keine Tendenz zur Diffusion in die HTSL-Schicht unter (nachteiliger) Veränderung der mechanischen und/oder physikalischen Eigenschaften derselben, insbesondere Verringerung der kritischen Stromdichte und/ oder des absoluten kritischen Stroms, haben.

Der die homogene Mischkristallphase bildende weitere Bestandteil ist erfindungsgemäß Cu und/oder Ag

Die oben genannten Übergangsmetalle können jeweils einzeln oder in Kombination eingesetzt werden, beispielsweise Kupfer und/oder Silber in Kombination mit einem oder mehreren weiteren der Metalle Ti, V, Cr, Mn oder Zn, gegebenenfalls auch Ti, Cr oder Zn. Gegebenenfalls können als weitere Metalle auch Fe, Ni und/oder Co eingesetzt werden, diese sind jedoch aufgrund der magnetischen Eigenschaften ihrer Verbindungen nicht bevorzugt. Gegebenenfalls kann der weitere Bestandteil alternativ oder zusätzlich auch andere Metalle enthalten, beispielsweise eines oder mehrere Metalle aus der Gruppe der Hauptgruppen-Metalle wie Alkali- und/oder Erdalkalimetalle, Metalle und Halbmetalle der dritten, vierten, fünften oder sechsten Hauptgruppe (wie beispielsweise B, Si, Ge, As, Se, Sb, Te), sofern diese mit dem Pufferschichtmaterial eine homogene Mischkristallphase bilden, die bei einer Glühbehandlung von ≤ 1.600°C oder den oben genannten Temperaturen zumindest eine partielle Schmelze bilden und bei niedrigeren Temperaturen, insbesondere den oben genannten Temperaturen, keinen Phasenumwandlungen oder Ausscheidungen anderer Phasen, einschließlich Bildung amorpher Phasen, unterliegen. Der weitere Bestandteil liegt vorzugsweise als Oxid vor und bildet mit dem Pufferschichtmaterial ein Mischoxid, wobei der weitere Bestandteil mittels eines Precursors eingebracht werden kann. Der weitere Bestandteil liegt vorzugsweise überwiegend oder vollständig in einer mittleren oder niedrigen Oxidationsstufe > 0 vor, z.B. in einer Oxidationsstufe von 1,2, 3 oder 4, vorzugsweise 1 bis 3 oder einer Oxidationsstufe 1 oder 2, sofern diese Oxidationsstufe ausreichend stabil ist. Insbesondere kann Kupfer als Cu(I) vorliegen.

Der mindestens eine weitere Bestandteil oder die Kombination der weiteren Bestandteile können in einem Gehalt von bis zu 40 at.-% bezogen auf den Gesamtmetallgehalt der Pufferschicht vorliegen, gegebenenfalls auch in einem höheren Gehalt, sofern mit dem Pufferschichtmaterial eine homogene Mischkristallphase gebildet wird, die vorzugsweise auch unterhalb der Glühtemperatur beständig ist, wie oben angegeben. Der weitere Bestandteil liegt erfindungsgemäß in einem Gehalt von ≥ 2 at.-% oder ≥ 3 bis 5 at.-%, vorzugsweise in einem Gehalt von ≥ 7 bis 10 at.-% vor, jeweils bezogen auf den Gesamtmetallgehalt des Pufferschichtmaterials. Der Gehalt des mindestens einen oder die Kombination der weiteren Bestandteile kann ≤ 30 bis 35 at.-%, gegebenenfalls ≤ 20 bis 25 at.-% bezogen auf den Gesamtmetallgehalt der Pufferschicht betragen.

Das Pufferschichtmaterial, welches erfindungsgemäß mit dem mindestens einen weiteren Bestandteil unter Bildung einer homogenen Mischkristallphase dotiert wird, kann ein Seltenerdenmetalloxid, insbesondere ein binäres, ternäres oder multinäres Seltenerdenmetalloxid, ein Oxid eines Übergangsmetalls, insbesondere der zweiten oder dritten Nebengruppe gegebenenfalls aber auch der ersten Nebengruppe, oder ein Hauptgruppenmetalloxid, jeweils einschließlich ein binäres, ternäres oder multinäres Oxid derselben sein. Das Pufferschichtmaterial kann auch ein Seltenerdenmetall-Übergangsmetall-Oxid sein, wobei das Übergangsmetall ein solches der ersten, zweiten und/oder dritten, vorzugsweise der zweiten und/oder dritten, Nebengruppe sein kann. Seltenerdenmetalle im Sinne der Erfindung sind Sc, Y, La und die Lanthanoiden (Ln). Das Pufferschichtmaterial kann gegebenenfalls auch ein einfaches Oxid eines Seltenerdenmetalls, Hauptgruppenmetalls oder Übergangsmetalls sein. Beispielsweise kann das Pufferschichtmaterial ein Zirkonat, Aluminat, Titanat, Manganat oder Ruthenat sein. Dass Pufferschichtmaterial kann zum Beispiel auch Zirkonoxid, insbesondere Yttrium-stabilisiertes Zirkonoxid (YSZ), Nickeloxid, Ceroxid, Magnesiumoxid oder gegebenenfalls auch ein anderes Erdalkalimetalloxid sein.

Besonders bevorzugt ist das den weiteren Bestandteil aufnehmende Pufferschichtmaterial ein Seltenerdenmetalloxid, vorzugsweise ein binäres oder multinäres Seltenerdenmetalloxid, welches die allgemeine Formel RE₂₊ₓM_{2+y}O_{z} mit -2 ≤ x, y ≤ 2, vorzugsweise -1 ≤ x, y ≤ 1, aufweisen kann, wobei vorzugsweise gilt, wenn x ≤ 0 ist y ≥ 0 und wenn y ≤ 0 ist x ≥ 0. Vorzugsweise ist jeweils x = -y. x, y können unabhängig voneinander jeweils 0 sein. Es kann sein x + y = ± ∂, wobei ∂ ≤ 0,5 bis 1, vorzugsweise ≤ 0,2 bis 0,3 oder ≤ 0,15 bis 0,1 sein kann. Ist ∂ kleiner 0, so kann das Kationenteilgitter Leerstellen aufweisen, ist ∂ größer 0, so können interstitielle Lagen wie z.B. Oktaederlücken zusätzlich besetzt sein. Insbesondere kann ∂ gleich 0 sein. RE ist eines oder mehrere Seltenerdenmetalle und M eines oder mehrere zwei, drei-, vier- oder fünfwertige Metalle, einschließlich Seltenerdenmetalle. z kann insbesondere im Bereich zwischen 5 und 8 variieren, beispielsweise im Bereich von 6 bis 8. Insbesondere kann die Formel RE₂₊ₓM_{2+y}O₅₋₈, mit -1 ≤ x, y ≤ 1, oder RE₂₊ₓM_{2+y}O_{7±2z} mit -1 ≤ x, y ≤ 1 und 0 ≤ z ≤ 0,5, gelten, besonders bevorzugt kann die Formel RE₂₊ₓM_{2+y}O₅₋₈, mit -0,5 ≤ x, y ≤ 0,5, oder RE₂₊ₓM_{2+y}O_{7±2z} mit -0,5 ≤ x, y ≤ 0,5 und 0 ≤ z ≤ 0,5, gelten, wobei im übrigen das oben Gesagte gelten kann. Allgemein hat z einen solchen Wert, dass hierdurch die neutrale Ladungsbilanz hergestellt wird. Es kann sein 5≤z≤8 oder z=7.

RE kann jeweils eines oder mehrere Metalle ausgewählt aus der Gruppe La, Y und Ln (Ce, Pr, Nd, Pm, Sm, Eu, Gd, Tb, Dy, Ho, Er, Tm, Yb, Lu) sein, insbesondere nur aus der Gruppe La und Ln oder nur aus der Gruppe Ln. Insbesondere kann Ln jeweils eines oder mehrere Metalle aus der Gruppe Ce, Nd, Sm, Eu, Gd, Yb sein. Unabhängig hiervon oder in Kombination hiermit kann M eines oder mehrere Metalle sein ausgewählt aus der Gruppe der Übergangsmetalle, einschließlich Lanthanoiden (Ln), und Hauptgruppenmetalle, einschließlich Zn. M kann eines oder mehrere Metalle aus der Gruppe der Übergangsmetalle, einschließlich Lanthanoiden, oder eines oder mehrere Metalle aus der Gruppe der Seltenerdenmetalle oder aus der Gruppe bestehend aus Lanthan und der Lanthanoiden sein. M kann jeweils auch ein oder mehrere Metalle der Übergangsmetalle der ersten, zweiten und/oder dritten Nebengruppe sein, vorzugsweise der zweiten und/oder dritten Nebengruppe, jeweils ausgenommen der Lanthanoiden und Actinoiden. Gegebenenfalls können für M auch ein oder mehrere Lanthanoiden in Kombination mit einem oder mehreren von den Lanthanoiden und Actinoiden verschiedenen Übergangsmetallen vorliegen. Gegebenenfalls kann M jeweils auch Sc, La und Y einschließen. Vorzugsweise ist M ein oder mehrere Metalle mit einer Wertigkeit von drei bis fünf, insbesondere von drei bis vier oder von vier bis fünf. Sind M mehrere Metalle, so haben diese vorzugsweise dieselbe Wertigkeit, vorzugsweise 3, 4 oder 5. So kann M jeweils eines oder mehrere Metall aus der Gruppe Sr, Ba, Ga, In, Tl, Sn, Pb, Bi, oder auch As, Sb, Se oder Te oder Tantal, Niob sein. Alternativ oder zusätzlich kann M eines oder mehrere Metalle aus der Gruppe Seltenerdenmetall, Hafnium, Zirkon, Tantal, Niob sein. Besonders bevorzugt ist M eines oder mehrere Metalle von Cer, Hafnium oder Zirkon, insbesondere Cer. Das Seltenerdenmetall (insbesondere auch Cer), Hafnium oder Zirkon können wie unten beschrieben teilweise substituiert sein, insbesondere jeweils gegen ein anderes Metall aus der Gruppe von Seltenerdenmetall, insbesondere Cer, Hafnium und Zirkon. Gegebenenfalls kann dasselbe Metallatom wie z. B. ein Seltenerdenmetall, einschließlich Ln, Hf oder Zr auch auf verschiedenen Lagen vorhanden sein.

Insbesondere kann das den weiteren Bestandteil aufnehmende Puffermaterial zwei oder mehr verschiedene Seltenerdenmetalle RE und RE' aufweisen, die jeweils unabhängig voneinander insbesondere La, Y oder ein Lanthanoid (Ln) wie Ce, Pr, Nd, Sm, Eu, Gd, Tb, Dy, Ho, Er, Tm, Yb, Lu sein können, insbesondere Ce, Nd, Sm, Eu, Gd, Yb, im speziellen Ce. Insbesondere kann jeweils RE gleich La und/oder Y sein. RE und RE' können jeweils unabhängig voneinander auch ausgewählt sein aus der Gruppe Ce, Nd, Sm, Eu, Gd, Yb, im speziellen Ce, insbesondere wenn RE gleich La oder Y ist. Das den weiteren Bestandteil aufnehmenden Pufferschichtmaterial kann hierbei die Formel RE₂₊ₓRE' _{2+y}O_{7±z}, RE₂RE' ₂O_{7±z}, La₂₊ₓRE_{2+y}O_{7±z} (mit RE ungleich La), La₂RE₂O_{7±z} (mit RE ungleich La), La₂₊ₓLn_{2+y}O_{7±z},La₂Ln₂O_{7±z},oder Ln₂₊ₓLn' _{2+y}O_{7±z}, Ln₂Ln' ₂O_{7±z} aufweisen, jeweils mit -2 ≤ x, y ≤ 2 oder vorzugsweise -1 ≤ x, y, z ≤ 1, wobei La jeweils teilweise oder vollständig durch Y substituiert sein kann. Besonders bevorzugt ist jeweils mit -0,5 ≤ x, y ≤ 0,5, wobei im Übrigen das oben Gesagte gelten kann. Vorzugsweise ist jeweils wenn x ≤ 0 ist y ≥ 0 und wenn y ≤ 0 ist x ≥ 0. Vorzugsweise ist jeweils x = -y. Allgemein hat z einen solchen Wert, dass hierdurch die neutrale Ladungsbilanz hergestellt wird, insbesondere einen Wert, so dass gilt 5 ≤ 7 ± z ≤ 8 ist, wobei z auch 0 sein kann.

Insbesondere kann das den weiteren Bestandteil aufnehmende Puffermaterial ein Seltenerdenmetall(RE)-Übergangsmetall(TM)-Oxid sein, wobei TM ein Übergangsmetall ausgenommen der Lanthanoiden und Actinoiden ist, beispielsweise nach der allgemeinen Formel (La, Ln) ₂₊ₓTM_{2+y}O_{7±2Z}, (La, Ln) ₂TM₂O_{7±2z}, RE₂₊ₓTM_{2+y}O_{7±2z}, RE₂TM₂O_{7±2z}, Ln₂₊ₓTM_{2+y}O_{7±2z}, Ln₂TM₂O_{7±2z}, La₂₊ₓTM_{2+y}O_{7±2z} oder La₂TM₂O_{7±2z}, wobei RE, Ln und/oder TM gegebenenfalls jeweils nur ein Metall ausgewählt aus der jeweiligen Gruppe sein können, und wobei jeweils -2 ≤ x, y ≤ 2 oder vorzugsweise -1 ≤ x, y, z ≤ 1, besonders bevorzugt jeweils -0,5 ≤ x, y ≤ 0,5. (La,Ln) zeigt an, dass La und/oder Ln vorliegen können. Es können jeweils auch unabhängig voneinander x und/oder y = 0 sein. Vorzugsweise ist jeweils wenn x ≤ 0 ist y ≥ 0 und wenn y ≤ 0 ist x ≥ 0. Vorzugsweise ist jeweils x = -y. Allgemein hat z einen solchen Wert, dass hierdurch die neutrale Ladungsbilanz hergestellt wird. Für z kann jeweils gelten 0 ≤ z ≤ 1 oder 0 ≤ z ≤ 0,5, oder es ergibt sich jeweils für 5 ≤ 7 ± 2z ≤ 8 ist.

Das Pufferschichtmaterial (ohne den weiteren Bestandteil) kann insbesondere ausgewählt sein aus RE₂₊ₓCe₂₊yO_{7+z}, RE₂Ce₂O_{7+z} (bevorzugt RE = La, Nd, Sm, Eu, Gd, Y und Yb) oder (La,Ln) ₂₊ₓCe_{2+y}O_{7+z}, (La,Ln)₂Ce₂O_{7+z} (bevorzugt Ln = Nd, Sm, Eu, Gd und Yb, insbesondere Sm, Eu, Gd, Yb), RE₂₊ₓZr_{2+y}O_{7+z}, RE₂Zr₂O_{7+z} (bevorzugt RE = La, Nd, Sm, Eu, Gd, Y und Yb) oder (La,Ln)₂₊ₓZr_{2+y}O_{7+z}, (La,Ln)₂Zr₂O_{7+z} (bevorzugt Ln = Nd, Sm, Eu, Gd und Yb, insbesondere Gd, Sm und/oder Nd). Hierbei kann Ce teilweise oder vollständig substituiert sein, z.B. gegen Hf, Ti, Zr, Ta, Nb und/oder Sn. Das Pufferschichtmaterial kann auch eine Phase der Zusammensetzung (Ln' ₂₋ₓLn'' x) M₂O_{7+z} sein, wobei M beispielsweise Zr, Hf, Ti oder Sn sein kann, insbesondere Zr. Auch dieses Material kann jeweils mit einem Übergangsmetall dotiert sein. Allgemein hat z einen solchen Wert, dass hierdurch die neutrale Ladungsbilanz hergestellt wird, insbesondere einen Wert, so dass gilt 5 ≤ 7 ± z ≤ 8 ist, wobei z auch 0 sein kann.

Es können jeweils unabhängig voneinander x und/oder y = 0 sein. Es kann jeweils -2 ≤ x, y ≤ 2 sein, vorzugsweise -1 ≤ x, y, z ≤ 1, besonders bevorzugt jeweils -0,5 ≤ x, y ≤ 0,5. Vorzugsweise ist jeweils wenn x ≤ 0 ist y ≥ 0 und wenn y ≤ 0 ist x ≥ 0. Vorzugsweise ist jeweils x = -y. Allgemein hat z einen solchen Wert, dass hierdurch die neutrale Ladungsbilanz hergestellt wird, insbesondere einen Wert, so dass gilt 5 ≤ 7 ± z ≤ 8 ist, wobei z auch 0 sein kann. Für z kann jeweils gelten 0 ≤ z ≤ 1 oder 0 ≤ z ≤ 0,5.

Das Puffermaterial kann auch ein binäres oder mutlinäres Seltenerdenmetall-Cer-Oxid sein, welches auch weitere Komponenten aufweisen und beispielsweise ein Hauptgruppenmetall-Seltenerdenmetall-Cer-Oxid, ein Übergangsmetall-Seltenerdenmetall-Cer-Oxid oder Mischformen zwischen diesen sein kann, wie ein Hauptgruppenmetall-Übergangsmetall-Seltenerdenmetall-Cer-Oxid.

Allgemein kann TM auch in verschiedenen Oxidationsstufen vorliegen, insbesondere wenn zwei oder mehr verschiedene Übergangsmetalle vorliegen. Vorzugsweise ist TM jeweils nur ein Metall der Übergangsmetalle.

Insbesondere kann das Pufferschichtmaterial (ohne den weiteren Bestandteil) ein Seltenerdenoxid der allgemeinen Formel RE₂₋ₓRE' ₓM_{2-y}M' _{y}O_{7±z} oder Ln₂₋ₓLn' ₓM_{2-y}M' _{y}O_{7±2z} mit 0 ≤ x, y, z ≤ 1, insbesondere 0 ≤ z ≤ 0,5, sein, wobei RE und RE', Ln und Ln' sowie M und M' jeweils verschiedene Metalle aus den genannten Gruppen sind, vorzugsweise jeweils drei- oder vier- oder fünfwertige Metalle. Besonders bevorzugt ist jeweils -0,5 ≤ x, y ≤ 0,5. Allgemein hat z einen solchen Wert, dass hierdurch die neutrale Ladungsbilanz hergestellt wird, insbesondere einen Wert, so dass gilt 5 ≤ 7 ± 2z ≤ 8 ist, wobei z auch 0 sein kann.

Das Puffermaterial kann auch ein binäres oder mutlinäres Seltenerdenmetall-Cer-Oxid sein, welches auch weitere Komponenten aufweisen und beispielsweise ein Hauptgruppenmetall-Seltenerdenmetall-Cer-Oxid, ein Übergangsmetall-Seltenerdenmetall-Cer-Oxid oder Mischformen zwischen diesen sein kann, wie ein Hauptgruppenmetall-Übergangsmetall-Seltenerdenmetall-Cer-Oxid.

Allgemein können die Oxide jeweils in Bezug auf die Metallkomponenten und/oder den Sauerstoffgehalt stöchiometrisch oder nicht-stöchiometrisch sein können, z.B. im Sinne von Mischverbindungen oder in Form von Defektverbindungen. Die Seltenerdenmetalloxide können 2, 3 oder mehr unterschiedliche Seltenerdenmetalle enthalten. Sind Übergangsmetalle enthalten, so können 1, 2, 3 oder mehr unterschiedliche Übergangsmetalle enthalten sein. Die Übergangsmetalle können jeweils dieselbe oder unterschiedliche Oxidationsstufen aufweisen. In den oben angegebenen Formeln kann jeweils unabhängig voneinander auch x = 0 und/oder y = 0 sein. Allgemein kann in den obigen Formeln auch 0 ≤ x, y ≤ 0,5 oder 0 ≤ x, y ≤ 0,25, 0 ≤ x, y ≤ 1 oder 0 ≤ x, y ≤ 0,05 sein. Allgemein hat z einen solchen Wert, dass hierdurch die neutrale Ladungsbilanz hergestellt wird.

Gegebenenfalls kann das Pufferschichtmaterial auch Ceroxid (CeO₂ oder CeO_{2-z}) sein. Cer kann hierbei teilweise unter Bildung binärer Oxide substituiert sein gegen Al, Hf, Ti, Zr, Sn, Ta, Nb oder ein anderes Seltenerdenmetall, insbesondere La, Nd, Sm, Eu, Gd, Y und Yb.

Die Seltenerdenmetalle der oben genannten Oxide können teilweise durch andere Übergangsmetalle, z.B. Übergangsmetalle der ersten, zweiten und/oder dritten Nebengruppe, insbesondere durch Metalle der zweiten und/oder dritten Nebengruppe (jeweils ausgenommen der Lanthanoiden und Actinoiden) substituiert sein. Hierbei können einzelne Lagen in den Kristallstrukturen der Seltenerdenmetalloxide teilweise oder vollständig substituiert sein, beispielsweise unter Bildung homogener Mischkristallphasen. Gegebenenfalls können die Seltenerdenmetalle und/oder Übergangsmetalle der oben genannten Oxide auch unabhängig voneinander teilweise durch Hauptgruppenmetalle ersetzt sein, beispielsweise durch eines oder mehrere Metalle aus der Gruppe von Alkalimetallen, beispielsweise Cs, Rb, Erdalkalimetallen, beispielsweise Ba, Sr, Metallen der dritten Hauptgruppe oder mit Metallen oder Halbmetallen der vierten oder fünften Hauptgruppe, beispielsweise auch Sn, Pb, Sb oder auch Zn. Die Substitution kann im Hinblick auf einzelne Lagen vollständig unter Bildung stöchiometrischer Abwandlungen oder unter Bildung nicht-stöchiometrischer Mischkristallphasen erfolgen. Die Seltenerden- und/oder Übergangsmetalle können jeweils durch eines oder mehrere andere der genannten Metalle ersetzt werden. Es versteht sich, dass bei den Seltenerdenmetalloxiden in einer, mehreren oder in sämtlichen Lagen der Kristallstrukturen jeweils auch mehrere Seltenerdenmetalle angeordnet sein können. Entsprechend können alternativ oder zusätzlich auch die Übergangsmetalle teilweise gegen eines oder mehrere Übergangsmetalle ersetzt sein. Es versteht sich, dass allgemein auch nur eine der beiden Lagen RE oder M in dem Seltenerdenmetalloxid der oben angegebenen Formeln substituiert sein kann.

Bei den genannten Seltenerdenmetalloxiden kann der Seltenerdenmetallgehalt ≥ 5-10 at.-%, ≥ 20-30 at.-% oder ≥ 40-50 at.-% betragen, gegebenenfalls auch ≥ 60-70 at.-%, bezogen auf den Gesamtmetallgehalt. Der Seltenerdenmetallgehalt der oben genannten Oxide kann jeweils auch ≤ 95-90 at.-%, ≤ 70-80 at.-% oder ≤ 50-60 at.-% betragen, gegebenenfalls auch ≤ 30-40 at.-% oder ≤ 20-25 at.-%, jeweils bezogen auf den Gesamtmetallgehalt. Diese Angaben beziehen sich auf das ursprüngliche Puffermaterial, d.h. ohne den weiteren bei ≤ 1600°C eine partielle Schmelze bildenden Bestandteil, sie können sich auch auf das den weiteren Bestandteil enthaltende Puffermaterial beziehen. Das ursprüngliche binäre oder multinäre Puffermaterial kann somit bei wesentlichen höheren Temperaturen eine (partielle) Schmelze bilden, z.B. bei ≥ 1700-1800°C oder bei ≥ 1900-200°C. Durch die genannten Substitutionen bzw. Dotierungen können jedoch das Aufwachsverhalten, Texturübertrag, Haftfestigkeit und/oder die für die Precursorzersetzung erforderlichen Bedingungen, z.B. auch die notwendige Atmosphäre, mitbestimmt werden.

Das Pufferschichtmaterial kann allgemein im Hinblick auf Sauerstoff eine Phasenbreite aufweisen, beispielsweise kann in den oben genannten Verbindungen z zwischen 0 und ± 1 oder 0 und ± 0,5 variieren, gegebenenfalls kann das Sauerstoffgitter somit auch unterstöchiometrisch sein, d.h. z kann kleiner 0 sein, vorzugsweise jedoch nicht kleiner -1.

Das Pufferschichtmaterial, insbesondere das den weiteren Bestandteil enthaltende Pufferschichtmaterial, kann beispielsweise im NaCl-, Fluorit-, Pyrochlor-, im Perowskittyp oder im GdFeO3-Typ kristallisieren, gegebenenfalls einschließlich geordneter Überstrukturen derselben, insbesondere im Fluorittyp, im Pyrochlortyp oder gegebenenfalls einer andere Fluoritüberstruktur. Es versteht sich, dass der Gehalt des weiteren Bestandteils derart ausgewählt sein kann, dass eine optimale Anpassung der Gitterkonstanten des Pufferschichtmaterials an die des Trägermaterials und/oder des HTSL-Materials bezogen auf die Gitterkonstanten in der Schichtebene der Schichtenanordnung liegen kann, gegebenenfalls unter Berücksichtigung von Überstrukturen. So können die Gitterkonstanten des Pufferschichtmaterials zumindest in etwa in den mittleren Bereich der Gitterkonstanten des Trägermaterials und der HTSL-Schicht liegen, beispielsweise mit Abweichung von ≤ ± 5-8 % oder ≤ 2-3 % oder ≤ 0,75-1 %, jeweils bezogen auf den mittleren Absolutwert der Gitterkonstanten des Trägermaterials und des HTSL-Materials in der Hauptebene der Schichtenanordnung, wobei im Falle von Überstrukturen entsprechendes für die auf die Elementarzelle des Trägermaterials transponierten und skalierten Gitterkonstanten des Pufferschichtmaterials gilt.

Die Pufferschicht kann aus mehreren Einzelschichten bestehen, die sich jeweils in ihrer Zusammensetzung unterscheiden können, z.B. hinsichtlich des Pufferschichtmaterials, des Gehaltes oder der Spezies des weiteren, eine Mischphase bildenden Bestandteils. Die einzelnen Pufferschichten können aber auch zumindest im Wesentlichen dieselbe Zusammensetzung aufweisen, z.B. um eine Pufferschicht größerer Dicke zu erzeugen.

Die den weiteren Bestandteil enthaltende MischkristallphasenPufferschicht kann unmittelbar auf dem Trägermaterial aufgebracht sein kann. Es kann gegebenenfalls auch auf dem Trägermaterial auch eine "Keimbildungsschicht" aufgebracht sein, die aus einem oxidischen Material wie einem Titanat oder Zirkonat bestehen kann, beispielsweise aus Calciumtitanat. Diese Keimbildungschicht dient nicht als Pufferschicht sondern im Wesentlichen der Konfektionierung der Trägermaterialoberfläche. Sie besteht in der Regel aus einer Vielzahl isolierter, inselartiger Strukturen und stellt keine ausreichende Diffusionsbarriere dar.

Alternativ oder zusätzlich kann bei der aus mehreren Schichten bestehende Pufferschicht der weitere Bestandteil, der mit dem Pufferschichtmaterial eine Mischkristallphase bildet, die an die HTSL-Schicht angrenzende Schicht bilden. Die weiteren Schichten der Pufferschicht können herkömmliche Pufferschichten sein, die einen weiteren eine Mischkristallphase bildenden Bestandteil nicht aufweisen. Gegebenenfalls können auch mehrere erfindungsgemäße Puffermaterialschichten mit jeweils einem oder mehreren eine Mischphase bildenden Bestandteil vorgesehen sein, wobei in den einzelnen Schichten unterschiedliche Bestandteile oder Bestandteile in unterschiedlichen Gehalten vorliegen. Zur Ausbildung der mehrere Schichten umfassenden Puffermaterialschicht können beispielsweise die Puffermaterialien in Form von lösungsmittelhaltigen Lösungen auf das jeweilige Substrat aufgebracht werden und das Lösungsmittel teilweise oder vollständig entfernt werden. Gegebenenfalls kann sich hieran eine thermische Behandlung anschließen. Nachfolgend hierzu kann dann eine weitere Puffermaterialschicht der gleichen oder einer unterschiedlichen Zusammensetzung aufgebracht werden. Vorzugsweise erfolgt die Glühbehandlung unter Erzeugung des oxidkeramischen Puffermaterials nach Ausbildung sämtlicher Puffermaterialschichten, gegebenenfalls können nach einer Glühbehandlung auch weitere Puffermaterialschichten aufgebracht werden. Bei der nach Aufbringung der Puffermaterialschicht erfolgenden thermischen Behandlung kann das Lösungsmittel teilweise oder vollständig entfernt werden und das in Form eine Prekursors aufgebrachte Puffermaterial teilweise oder vollständig zersetzt werden.

Ist die Pufferschicht mehrschichtig ausgebildet, so können die jeweiligen Einzelschichten derart ausgebildet sein, dass diese bei einer niedrigeren Glühtemperatur eine zumindest partielle Schmelze bilden bzw. bei gegebener Glühtemperatur der Anteil (in Volumen oder Gewichtsanteilen) der Schmelze an der Gesamtpufferschicht zunimmt. Beispielsweise kann hierzu der Gehalt des Weiteren, eine homogene Mischkristallphase bildenden Bestandteils an dem Pufferschichtmaterial erhöht sein oder ein anders wirksamerer Bestandteil eingesetzt werden (z.B. Silber statt Kupfer). Die an die HTSL-Schicht angrenzende Einzelschicht des Puffermaterials kann hierbei einen niedrigeren Schmelzpunkt (inkongruenter Schmelzpunkt) aufweisen, als weiter von der HTSL-Schicht entfernte Puffermaterialschichten, die somit bei gleicher Temperatur nur einen geringeren Anteil an Schmelzphase bilden. Die an die HTSL-Schicht angrenzende Puffermaterialschicht kann hierdurch besonders glatt und besonders gleichmäßig, u. a. mit besonders niedriger Porosität, ausgebildet werden.

Insbesondere kann die den weiteren, eine homogene Mischphase bildenden Bestandteil aufweisende Pufferschicht auf einer Seltenerdenoxidschicht eines einfachen, binären oder multinären Oxids abgeschieden werden, z.B. auf einer Ceroxidschicht (CeO2, wobei die O-Lage auch unterstöchiometrisch sein kann), einer Seltenerden-Seltenerden-Oxidschicht oder einer Seltenerden-Übergangsmetallschicht (z.B. einer Lanthanzirkonatschicht, Seltenerdenzirkonatschicht, Seltenerdenceroxidschicht oder Übergangsmetallceroxidschicht), die die Zusammensetzung La2Zr2O7+x, RE2Zr207+x, RE2Ce2O7+x oder TM2Ce2O7+x aufweisen können, mit 0 ≤ x ≤ 1, wobei diese Substratschicht den weiteren, eine homogene Mischphase bildenden Bestandteil wie Kupfer nicht enthält. Die genannten Schichten können im Übrigen substituiert sein, wie auch oben zu den erfindungsgemäßen Pufferschichten ausgeführt ist und worauf hiermit Bezug genommen wird.

Die Ausbildung der erfindungsgemäßen Pufferschicht ermöglicht es andererseits, die Pufferschicht nur einschichtig auszubilden, so dass im Falle einer chemischen Lösungsbeschichtung (CSD) nur ein einmaliger Auftrag der Lösung des Pufferschichtmaterials erforderlich ist und nach der thermischen Vorbehandlung und Glühung bereits die HTSL-Schicht aufgebracht werden kann.

Das Pufferschichtmaterial kann in Form eines metallorganischen Prekursors, beispielsweise eines β-Diketonates, insbesondere eines Acetylacetonats, Alkylcarboxylats oder dergleichen aufgebracht werden. Allgemein kann ein geeignetes Lösungsmittel eingesetzt werden, welches enthalten oder bestehen kann aus einem Keton, z. B. Aceton, einem oder mehreren Alkoholen, einer oder mehreren Carbonsäuren ohne hierauf beschränkt zu sein. Insbesondere können C2-C8- oder C3-C6- oder C3-C4-Carbonsäuren eingesetzt werden, die jeweils geradkettig oder verzweigt sein können, insbesondere auch Propionsäure und/oder Pivalinsäure. Die oben genannten Lösungsmittel können gegebenenfalls auch in Kombination miteinander eingesetzt werden. Das organische Lösungsmittel kann im Wesentlichen wasserfrei sein.

Besonders bevorzugt wird das Pufferschichtmaterial in Form eines Alkylcarbonats, welches 1 bis 10, vorzugsweise 2 bis 8, oder 3 bis 6 C-Atome aufweist, eingesetzt werden, beispielsweise in Form eines Propionats oder Pivalinats. Das Alkylcarbonat kann allgemein geradkettig, verzweigt oder gegebenenfalls auch zyklisch sein.

Das Pufferschichtmaterial kann auch in wässriger Lösung aufgebracht werden, als wasserlösliche Salze sind insbesondere Nitrate, Carboxylate, insbesondere Acetate, Citrate oder Tartrate, einzeln oder in Kombination, einsetzbar. Die wässrige Lösung kann auf einen pH-Wert von 4-8, vorzugsweise 5-7 oder 6-7 eingestellt sein. Vorzugsweise ist die Lösung abgepuffert, insbesondere durch einen thermisch zersetzbaren oder verflüchtigbaren Puffer, insbesondere Ammoniak oder ein Ammoniumsalz.

Die Glühbehandlung zur Kristallisation des Puffermaterials kann zumindest teilweise in einer reduzierenden Atmosphäre erfolgen, beispielsweise unter Formiergas oder einem anderen geeignetem Gas mit zumindest ähnlichem Reduktionsvermögen, wobei das Formiergas (N2/H2) 0,1 bis 15 %, 0,2 bis 10 %, 0,5 bis 5 % oder 1 bis 5 %, z.B. ca. 3 % H2 enthalten kann (jeweils Volumenprozent). Die das Seltenerdenmetall-Cer-Oxid enthaltende, unmittelbar auf das Trägermaterial aufgebrachte Pufferschicht kann auch unter einer Glühbehandlung in einer nicht-reduzierenden Atmosphäre, beispielsweise unter reinem Stickstoff oder einem anderen inerten Gas, hergestellt werden. Dies kann auch unter Umständen für andere oder sämtliche Pufferschichten einer mehrlagigen Puffermaterialbeschichtung gelten. Wird die das Seltenerdenmetall-Cer-Oxid enthaltende Pufferschicht auf eine zwischen dieser und dem Trägermaterial angeordnete Zwischenschicht aus Puffermaterial aufgebracht, so kann die Pufferschicht unter einer Glühbehandlung in einer reduzierenden Atmosphäre hergestellt werden, z.B. unter Formiergas, was unter Umständen auch für die Herstellung anderer oder sämtlicher der erfindungsgemäßen Pufferschichten gelten kann. Allgemein können einzelne Pufferschichten unter einer nicht-reduzierenden Atmosphäre und andere Pufferschichten desselben Pufferschichtaufbaus einer HTSL-Schichtanordnung unter einer reduzierenden Atmosphäre hergestellt werden.

Die Glühbehandlung kann derart durchgeführt werden, dass die den weiteren Bestandteil enthaltenden Pufferschicht eine Porosität von ≤ 25-30%, ≤ 15-20%, ≤ 5-10%, besonders bevorzugt ≤ 2-3% oder ≤ 1% aufweist oder die Schicht zumindest im Wesentlichen porenfrei ist.

Die Glühbehandlung kann derart durchgeführt werden, dass die den weiteren Bestandteil enthaltenden Pufferschicht eine RMS-Rauheit (root-mean-squared roughness) von ≤ 2,5-2 nm, vorzugsweise ≤ 1,6-1,8 nm oder ≤ 1,2-1,4 nm, besonders bevorzugt ≤ 1,0-0,8 nm aufweist, bestimmt über ein Areal von 1x1µm².

Der auf die Pufferschicht aufgebrachte Hochtemperatursupraleiter kann ein Seltenerdenmetall-Kupfer-Oxid sein, insbesondere Seltenerdenmetall-Erdalkalimetall-Kupfer-Oxid, wobei unabhängig voneinander das Seltenerdenmetall Yttrium und das Erdalkalimetall Barium sein können. Es versteht sich, dass insbesondere das Seltenerdenmetall z.B. Yttrium und/oder das Erdalkalimetall wie z.B. Barium teilweise gegen andere Metalle, beispielsweise durch andere Seltenerden- oder Erdalkalimetalle, substituiert sein können. Das HTSL-Material kann insbesondere ein Y-Ba-Cu-Oxid (YBa₂Cu₃Oₓ) oder ein Bi-Sr-Ca-Cu-Oxid sein. Als Hochtemperatursupraleiter im Sinne der Erfindung sei allgemein ein Supraleiter mit einer Sprungtemperatur von ≥ 77 Kelvin verstanden, gegebenenfalls allgemein kann aber auch ein anderer keramischer (oxidischer) Supraleiter auf der Pufferschicht aufgebracht werden.

Allgemein kann die Pufferschicht eine Dicke von 0,02 - 2 µm oder allgemein ≤ 5 µm aufweisen, ohne hierauf beschränkt zu sein, gegebenenfalls im Bereich von 0,1 - 1 µm, 0,1 - 0,5 µm oder im Bereich von 0,1 - 0,3 µm. Die Dicke des Trägermaterials ist nicht limitiert, solange dies eine ausreichende mechanische Festigkeit aufweist, sie kann im Bereich 5-1000µm, von 10-500µm, von 25-250µm oder im Bereich von 50-100µm liegen. Auf dem Trägermaterial kann vorzugsweise mit inselartiger Struktur ein das Aufwachsen der Pufferschicht förderndes Material aufgebracht sein. Die HTSL-Schicht kann, ohne hierauf beschränkt zu sein, eine Dicke von ≥ 0,05µm, insbesondere im Bereich von 0,1-50µm oder von 0,25-10µm, vorzugsweise von 0,5-5µm aufweisen.

Das Trägermaterial kann ein geeignetes Metall oder eine Legierung sein, z.B. Nickel, eine Nickellegierung wie z. B. Wolframdotiertes Nickel (beispielsweise Ni mit 5-10 at.-%W), Hastelloy oder dergleichen.

Die Erfindung wir im Folgenden beispielhaft beschrieben und anhand der Ausführungsbeispiele erläutert.

Alle Beschichtungen erfolgten in einer kontinuierlichen Bandbeschichtungsanlage mit integrierter Trockenstrecke durch Tauchbeschichtung, es kann jedoch auch ein anderes Flüssigbeschichtungsverfahren eingesetzt werden, z.B. ein Druckverfahren, wie z.B. Tintenstrahl- oder Siebdruck, Sprühbeschichtungsverfahren, Beschichtungen über Kapillaren oder Schlitzdüse oder auch diskontinuierliche Beschichtungsverfahren. Die Zuggeschwindigkeit beträgt bei allen Beispielen 10m/h für ein Band mit 1cm Breite. Als Substratband wird in allen Fällen ein biaxialwalztexturiertes Ni-5at%W-Band mit 80µm Dicke verwendet. Von allen Beschichtungslösungen wurden jeweils 10ml hergestellt.

Die Schichtdicke wurde mittels Ellipsometermessungen (omt, VisuEL 3.6.2) bestimmt. Mikrorisse wurden über Dunkelfeldbetrachtungen an einem optischen Mikroskop (Zeiss Axiotech) oder einem Resterelektronenmikroskop (JEOL 6400F) beurteilt. Die Analyse der Porosität erfolgte mittels TEM-Messungen (Querschnitt) sowie mittels Ellipsometermessungen (omt, VisuEL 3.6.2). Die Rauheit wurde an einem AFM (Veeco CP-II) über ein Areal von 1x1µm² bestimmt, wobei eine Standard Si3N4-Spitze mit k=0,06 N/m verwendet wurde. Die Kantenlänge des Areals ist dabei deutlich größer als die Korngrößen des Pufferschichtmaterials und deutlich geringer als die Korngrößen des Metallsubstrates. Dadurch ist sichergestellt, dass mehrere Keramikkörner des Pufferschichtmaterials innerhalb eines Substratkorns vermessen werden.

Alle Resultate sind in der Ergebnistabelle zusammengefasst.

### Beispiel 1: Ceroxid

Wasserfreies Cerpropionat wird in Propionsäure so gelöst, dass eine 0,2 molare Lösung entsteht.

Für eine Serie von 5 Beschichtungslösungen (la - 1e) werden zu dieser Lösung werden nun 5, 10, 15, 20 bzw. 25 at% Kupferpropionat bezogen auf Cer zugegeben und die Lösung mit Propionsäure wieder auf 0,2mol bezogen auf die Summe der Metallionen verdünnt. Als Vergleichsprobe wurde eine Kupfer-freie Lösung (1f) hergestellt.

Die Lösungen werden gemäß allgemeiner Versuchsbeschreibung auf ein Substratband aufgebracht, auf welchem sich bereits eine Lanthanzirkonatschicht befindet. Die Trocknung erfolgt innerhalb von 10min bei 120°C unter Luft, die Glühbehandlung erfolgt innerhalb von 30min bei 1000°C unter reduzierenden Bedingungen, genauer unter Formiergas (3% H2 in N2).

### Beispiel 2: Ceroxid

Ceracetat wird in Propionsäure so gelöst, dass eine 0,2 molare Lösung entsteht. Für die Beschichtungslösung werden zu dieser Lösung nun 10at% Kupferacetat bezogen auf Cer zugegeben und die Lösung mit Propionsäure wieder auf 0,2mol bezogen auf die Summe der Metallionen verdünnt.

Die Lösungen werden gemäß allgemeiner Versuchsbeschreibung auf ein Substratband aufgebracht, auf welchem sich bereits eine doppelte Lanthanzirkonatschicht befindet. Die Trocknung erfolgt innerhalb von 10min bei 120°C unter Luft, die Glühbehandlung erfolgt innerhalb von 30min bei 1100°C unter Formiergas (1%H2 in N2).

### Beispiel 3: Cer-Gadolinium-Oxid

Ceracetat und Gadoliniumacetat werden in Propionsäure im Verhältnis 4:1 so gelöst, dass eine 0,2 molare Lösung bezogen auf die Summe der Metallionen entsteht. Für die Beschichtungslösung werden zu dieser Lösung nun 15at% Kupferacetat bezogen auf die Summe aus Cer und Gadolinium zugegeben und die Lösung mit Propionsäure wieder auf 0,2mol bezogen auf die Summe der Metallionen verdünnt.

Die Lösungen werden gemäß allgemeiner Versuchsbeschreibung auf ein Substratband aufgebracht, auf welchem sich bereits eine doppelte Lanthanzirkonatschicht befindet. Die Trocknung erfolgt innerhalb von 10min bei 150°C unter Luft, die Glühbehandlung erfolgt innerhalb von 30min bei 1000°C unter Formiergas (5%H2 in N2).

### Beispiel 4: Ceroxid

Ceracetylacetonat wird in Propionssäure so gelöst, dass eine 0,2 molare Lösung entsteht. Für die Beschichtungslösung werden zu dieser Lösung nun 10at% Silberacetat bezogen auf Cer zugegeben und die Lösung mit Propionsäure wieder auf 0,2mol bezogen auf die Summe der Metallionen verdünnt.

Die Lösung wird gemäß der allgemeinen Versuchsbeschreibung auf ein Substratband aufgebracht, auf welchem sich bereits eine doppelte Lanthanzirkonatschicht befindet. Die Trocknung erfolgt innerhalb von 10min bei 100°C unter Luft, die Glühbehandlung erfolgt innerhalb von 20min bei 900°C unter Formiergas (3%H2 in N2).

### Beispiel 5a: Ceroxid

Cernitrat und Kupfernitrat (Verhältnis 9:1) werden in Zitronensäure in einem Verhältnis von 1:3 (Gesamtmetallionen : Zitronensäure) gelöst. Durch Zugabe von Ammoniak und Wasser wird eine 0,2molare Lösung mit einem pH-Wert von 6 hergestellt.

Die Lösung wird gemäß der allgemeinen Versuchsbeschreibung auf ein Substratband aufgebracht, auf welchem sich bereits eine doppelte Lanthanzirkonatschicht befindet. Die Trocknung erfolgt innerhalb von 30min bei 200°C unter Luft, die Glühbehandlung erfolgt innerhalb von 30min bei 900°C unter Formiergas (5%H2 in N2).

### Beispiel 5b: Ceroxid (Vergleichsbeispiel zu 5a)

Cernitrat und Citronensäure werden in Wasser so gelöst, dass bezogen auf Cerionen eine 0,2molare Lösung entsteht und deren Verhältnis von Metallionen zu Citronensäure 1:6 entspricht. Durch Zugabe von Ammoniak und Wasser wird eine Lösung mit einem pH-Wert von 6,4 hergestellt.

Die Lösung wird gemäß der allgemeinen Versuchsvorschrift auf ein Substratband aufgebracht, welches bereits doppelt mit Lanthanzirkonat beschichtet wurde. Die Trocknung erfolgt in 180 min bei 40 °C i.Vak., die Glühbehandlung erfolgt innerhalb von 20 min bei 950 °C unter Stickstoff (99,999%).

### Beispiel 6: Lanthanzirkonat

Lanthanpropionat, Zirkonpropionat und Kupferpropionat werden im molaren Verhältnis 9:9:1 so in Propionsäure gelöst, dass eine 0,4 molare Lösung in Bezug auf Lanthan entsteht.

Die Lösung wird gemäß der allgemeinen Versuchsbeschreibung auf ein Metallsubstratband aufgebracht. Die Trocknung erfolgt innerhalb von 10min bei 120°C unter Luft, die Glühbehandlung erfolgt innerhalb von 20min bei 1000°C unter Formiergas (5%H2 in N2).

### Beispiel 7: Lanthancerat

Lanthanpropionat, Cerpropionat und Kupferpropionat werden im molaren Verhältnis 9:9:1 so in Propionsäure gelöst, dass eine 0,4 molare Lösung in Bezug auf Lanthan entsteht.

Die Lösung wird gemäß der allgemeinen Versuchsbeschreibung unmittelbar auf ein Metallsubstratband aufgebracht. Die Trocknung erfolgt innerhalb von 10min bei 120°C unter Luft, die Glühbehandlung erfolgt innerhalb von 20min bei 950°C unter Formiergas (5%H2 in N2).

**Ergebnistabelle**

| Lösung-# | Schichtdicke / nm | Risse | Porosität / % | RMS-Rauheit / nm |
|---|---|---|---|---|
| 1a | 35 | wenige Mikrorisse | 24 | 1,2 |
| 1b | 32 | nein | 16 | 1,2 |
| 1c | 26 | nein | 10 | 0,6 |
| 1d | 29 | nein | 8 | 0,5 |
| 1e | 25 | wenige Mikrorisse | nicht nachweisbar | 1,8 |
| 1f (Referenz) | 33 | Mikrorisse | 35 | 2,8 |
| 2 | 22 | nein | 15 | 1,0 |
| 3 | 30 | nein | 12 | 0,8 |
| 4 | 28 | nein | 8 | 0,6 |
| 5a | 30 | nein | 14 | 1,2 |
| 5b (Referenz) | 21 | nein | 19 | 3,5 |
| 6 | 151 | nein | 10 | 2,5 |
| 7 | 165 | nein | 30 | 2,1 |

## Patentansprüche

1. Hochtemperatursupraleiter-Schichtanordnung umfassend mindestens ein Trägermaterial und eine texturierte Pufferschicht aus oxidischem Material, die ein texturiertes Aufwachsen einer Hochtemperatursupraleiter(HTSL)-Schicht ermöglicht, wobei das Trägermaterial texturiert ist und aus einem geeigneten Metall oder einer Legierung besteht, und wobei die Pufferschicht mindestens einen weiteren, eine homogene Mischkristallphase bildenden Bestandteil enthält, und wobei die Pufferschicht derart erhältlich ist, dass der weitere Bestandteil und das Pufferschichtmaterial und/oder jeweils deren Precursoren getrennt oder zusammen mittels einer chemischen Lösung auf der jeweiligen Unterlage abgeschieden werden und wobei, gegebenenfalls nach weiteren Abscheidungsschritten des Pufferschichtmaterial und/oder des weiteren Bestandteils, das beschichtete Substrat unter Bildung einer den weiteren Bestandteil enthaltenden homogenen Mischkristallphase einer Glühbehandlung unterzogen wird, **dadurch gekennzeichnet, dass** das Trägermaterial biaxial texturiert, dass der weitere Bestandteil der Pufferschicht Kupfer und/oder Silber einschließlich dessen jeweiligen Oxids ist und in einem Gehalt von 2 bis zu 40 at.-% bezogen auf den Gesamtmetallgehalt der Pufferschicht vorliegt.

2. Schichtanordnung nach Anspruch 1 **dadurch gekennzeichnet, dass** das den weiteren Bestandteil enthaltende Pufferschichtmaterial bei einer Glühtemperatur von ≤ 1.600 Grad Celsius mit dem oxidischen Puffermaterial zumindest eine partielle Schmelze bildet.

3. Schichtanordnung nach einem der Ansprüche 1 bis 2, **dadurch gekennzeichnet, dass** das den weiteren Bestandteil aufnehmende Pufferschichtmaterial zumindest aus einem Material besteht ausgewählt aus der Gruppe: Seltenerdenoxid, Hauptgruppenmetalloxid oder Übergangsmetalloxid, einschließlich jeweils binäre, ternäre oder multinäre Oxide derselben, Zirkonat, Aluminat, Titanat, Manganat, Ruthenat.

4. Schichtanordnung nach Anspruch 3, **dadurch gekennzeichnet, dass** das den weiteren Bestandteil aufnehmende Pufferschichtmaterial ein binäres oder multinäres Seltenerdenoxid ist, bei welchem die Metallkomponenten teilweise oder ausschließlich Seltenerdenmetalle sind und 2 oder mehr unterschiedliche Seltenerdenmetalle enthalten sind.

5. Schichtanordnung nach Anspruch 4, **dadurch gekennzeichnet, dass** das den weiteren Bestandteil aufnehmende Pufferschichtmaterial ein Seltenerdenmetalloxid der allgemeinen Formel RE₂₊ₓM_{2+y}O_{z} mit -2 ≤ x, y ≤ 2 ist, wobei RE eines oder mehrere Seltenerdenmetalle und M eines oder mehrere zwei, drei-, vier- oder fünfwertige Metalle, einschließlich Seltenerdenmetalle, sind.

6. Schichtanordnung nach einem der Ansprüche 1 bis 5, **dadurch gekennzeichnet, dass** die Porosität der den weiteren Bestandteil enthaltenden Pufferschicht ≤ 25% beträgt.

7. Schichtanordnung nach einem der Ansprüche 1 bis 6, **dadurch gekennzeichnet, dass** die den weiteren Bestandteil enthaltenden Pufferschicht eine RMS-Rauheit von ≤ 1,8 nm aufweist.

8. Schichtanordnung nach einem der Ansprüche 1 bis 7, **dadurch gekennzeichnet, dass** (i) die Pufferschicht mehrere Schichten aufweist, und dass die den weiteren Bestandteil enthaltende Mischkristallphasenpufferschicht, eine an die Hochtemperatursupraleiter-Schicht angrenzende Schicht bildet, und/oder dass (ii) die zwischen Trägermaterial und HTSL-Schicht angeordnete Pufferschicht nur Schichten aufweist, die einen weiteren, eine homogene Mischkristallphase bildenden weiteren Bestandteil aufweist, und/oder dass (iii) die Pufferschicht nur einschichtig ausgebildet ist.

9. Schichtanordnung nach einem der Ansprüche 1 bis 8, **dadurch gekennzeichnet, dass** auf der Pufferschicht ein Hochtemperatursupraleiter aufgebracht ist.

10. Verfahren zur Herstellung einer Hochtemperatursupraleiter-Schichtanordnung nach einem der Ansprüche 1 bis 9, wobei auf einem Trägermaterial, welches texturiert und ein Metall oder eine Legierung ist, eine texturierte Pufferschicht aufgebracht wird, die ein texturiertes Aufwachsen eines Hochtemperatursupraleiters ermöglicht, wobei in das Pufferschichtmaterial mindestens ein weiterer, eine homogene Mischkristallphase bildender Bestandteil eingebracht wird, der mindestens ein Übergangsmetall einschließlich in Form eines Oxids enthält, und wobei das Pufferschichtmaterial durch chemische Lösungsbeschichtung erzeugt und auf dem Trägermaterial aufgebracht wird, wobei der weitere Bestandteil und das Pufferschichtmaterial und/oder jeweils deren Precursoren getrennt oder zusammen mittels einer chemischen Lösung auf der jeweiligen Unterlage abgeschieden werden und wobei, gegebenenfalls nach weiteren Abscheidungsschritten des Pufferschichtmaterial und/oder des weiteren Bestandteils, das beschichtete Substrat unter Bildung einer den weiteren Bestandteil enthaltenden homogenen Mischkristallphase einer Glühbehandlung unterzogen wird, **dadurch gekennzeichnet, dass** als Übergangsmetall Kupfer und/oder Silber eingesetzt wird,.

11. Verfahren nach Anspruch 10, **dadurch gekennzeichnet, dass** ein Pufferschichtmaterial nach einem der Ansprüche 2 bis 8 aufgebracht wird und/oder dass auf der Pufferschicht ein Hochtemperatursupraleiter aufgebracht wird.

12. Verfahren nach einem der Ansprüche 10 oder 11, **dadurch gekennzeichnet, dass** die Pufferschicht in mehreren Schichten aufgebracht wird und dass die den weiteren Bestandteil enthaltende Mischkristallphasenpufferschicht auf dem Trägermaterial und/oder als die an die Hochtemperatursupraleiter-Schicht angrenzende Schicht ausgebildet wird.

13. Verfahren nach einem der Ansprüche 10 bis 12, **dadurch gekennzeichnet, dass** die Pufferschicht nur durch eine oder mehrere Schichten ausgebildet wird, die jeweils einen weiteren, eine homogene Mischkristallphase bildenden weiteren Bestandteil aufweisen.

14. Verfahren nach einem der Ansprüche 10 bis 13, **dadurch gekennzeichnet, dass** die Metallkomponenten des Puffermaterials und/oder des weiteren Bestandteils (i) zumindest teilweise oder vollständig als Alkylcarboxylate, Acetylacetonate oder in Form anderer vorzugsweise chelatbildender Komplexe in einem organischen Lösungsmittel auf das Trägermaterial oder eine bereits vorliegende Puffermaterialschicht, einschließlich dessen Vorstufen, aufgebracht wird, und/oder (ii) in Form wasserlöslicher Verbindungen in einer wässrigen Lösung auf das Trägermaterial oder eine bereits vorliegende Puffermaterialschicht, einschließlich dessen Vorstufen, aufgebracht wird.

15. Verfahren nach einem der Ansprüche 10 bis 14, **dadurch gekennzeichnet, dass** die Glühbehandlung zur Erzeugung der den weiteren Bestandteil enthaltenden Pufferschicht zumindest teilweise in einer reduzierenden Atmosphäre erfolgt.

## Claims

1. A high-temperature superconductor layer arrangement comprising at least one support material and a textured buffered layer which is composed of oxidic material and allows textured growing-on of a high-temperature superconductor (HTSL) layer, where the support material is textured and consists of a suitable metal or an alloy and the buffer layer comprises at least one further constituent which forms a homogeneous mixed crystal phase and the buffer layer is obtainable by the further constituent and the buffer layer material and/or in each case precursors thereof being deposited separately or together by means of a chemical solution on the respective substrate and, optionally after further deposition steps for the buffer layer material and/or the further constituent, the coated substrate being subjected to a heat treatment to form a homogeneous mixed crystal phase comprising the further constituent, wherein the support material is biaxially textured, the further constituent of the buffer layer is copper and/or silver including the respective oxides thereof and is present in a content of from 2 to 40 at.% based on the total metal content of the buffer layer.

2. The layer arrangement according to claim 1, wherein the buffer layer material comprising the further constituent forms at least a partial melt with the oxidic buffer material at a heat treatment temperature of ≤ 1600 degrees Celsius.

3. The layer arrangement according to either of claims 1 and 2, wherein the buffer layer material which takes up the further constituent consists at least of a material selected from the group consisting of: rare earth metal oxide, main group metal oxide and transition metal oxide, including in each case binary, ternary or multinary oxides of these, zirconate, aluminate, titanate, manganate, ruthenate.

4. The layer arrangement according to claim 3, wherein the buffer layer material which takes up the further constituent is a binary or multinary rare earth metal oxide in which the metal components are partly or exclusively rare earth metals and two or more different rare earth metals are comprised.

5. The layer arrangement according to claim 4, wherein the buffer layer material which takes up the further constituent is a rare earth metal oxide of the general formula RE₂₊ₓM_{2+y}O_{z} where -2 ≤ x, y ≤ 2, where RE is one or more rare earth metals and M is one or more divalent, trivalent, tetravalent or pentavalent metals, including rare earth metals.

6. The layer arrangement according to any of claims 1 to 5, wherein the porosity of the buffer layer comprising the further constituent is ≤ 25%.

7. The layer arrangement according to any of claims 1 to 6, wherein the buffer layer comprising the further constituent has an RMS roughness of ≤ 1.8 nm.

8. The layer arrangement according to any of claims 1 to 7, wherein (i) the buffer layer has a plurality of layers and the mixed crystal phase buffer layer comprising the further constituent forms a layer adjoining the high-temperature superconductor layer and/or (ii) the buffer layer arranged between support material and HTSL layer has only layers which have a further constituent forming a homogeneous mixed crystal phase and/or (iii) the buffer layer has only one layer.

9. The layer arrangement according to any of claims 1 to 8, wherein a high-temperature superconductor has been applied on top of the buffer layer.

10. A process for producing a high-temperature superconductor layer arrangement according to any of claims 1 to 9, wherein a textured buffer layer which allows textured growing-on of a high-temperature superconductor is applied to a support material which is textured and is a metal or an alloy, a further constituent which forms a homogeneous mixed crystal phase and comprises at least one transition metal exclusively in the form of an oxide is introduced into the buffer layer material and the buffer layer material is produced and applied to the support material by chemical solution coating, where the further constituent and the buffer layer material and/or in each case precursors thereof are deposited separately or together by means of a chemical solution on the respective substrate and, optionally after further deposition steps of the buffer layer material and/or of the further constituent, the coated substrate is subjected to a heat treatment to form a homogeneous mixed crystal phase comprising the further constituent, wherein copper and/or silver is used as transition metal.

11. The process according to claim 10, wherein a buffer layer material according to any of claims 2 to 8 is applied and/or a high-temperature superconductor is applied to the buffer layer.

12. The process according to either claim 10 or 11, wherein the buffer layer is applied in a plurality of layers and the mixed crystal phase buffer layer comprising the further constituent is formed on the support material and/or as the layer adjoining the high-temperature superconductor layer.

13. The process according to any of claims 10 to 12, wherein the buffer layer is formed only by one or more layers which each have a further constituent forming a homogeneous mixed crystal phase.

14. The process according to any of claims 10 to 13, wherein the metal components of the buffer material and/or of the further constituent are (i) applied at least partly or completely as alkyl carboxylates, acetylacetonates or in the form of other preferably chelate-forming complexes in an organic solvent to the support material or an existing buffer material layer, including precursors thereof, and/or (ii) applied in the form of water-soluble compounds in an aqueous solution to the support material or an existing buffer material layer, including precursors thereof.

15. The process according to any of claims 10 to 14, wherein the heat treatment for producing the buffer layer comprising the further constituent is carried out at least partly in a reducing atmosphere.

## Revendications

1. Agencement de couches de supraconducteur à haute température, comprenant au moins un matériau support et une couche tampon texturée en un matériau oxydique, qui permet une croissance texturée d'une couche de supraconducteur à haute température (HTSL), le matériau support étant structuré et constitué d'un métal approprié ou d'un alliage, et la couche tampon contenant au moins un constituant supplémentaire, formant une phase cristalline mixte homogène, et la couche tampon pouvant être obtenue par dépôt du constituant supplémentaire et du matériau de la couche tampon et/ou de leurs précurseurs respectifs séparément ou ensemble au moyen d'une solution chimique sur la sous-couche respective, et le substrat revêtu étant soumis à un traitement de recuit avec formation d'une phase cristalline mixte homogène contenant le constituant supplémentaire, éventuellement après des étapes de dépôt supplémentaires du matériau de la couche tampon et/ou du constituant supplémentaire, **caractérisé en ce que** le matériau support est texturé biaxialement, **en ce que** le constituant supplémentaire de la couche tampon est le cuivre et/ou l'argent, y compris leurs oxydes respectifs, et est présent en une teneur de 2 à 40 % at. par rapport à la teneur totale en métaux de la couche tampon.

2. Agencement de couches selon la revendication 1, **caractérisé en ce que** le matériau de couche tampon contenant le constituant supplémentaire forme à une température de recuit ≤ 1 600 degrés Celsius avec le matériau tampon oxydique au moins une masse fondue partielle.

3. Agencement de couches selon l'une quelconque des revendications 1 à 2, **caractérisé en ce que** le matériau de couche tampon recevant le constituant supplémentaire est constitué d'au moins un matériau choisi dans le groupe constitué par : un oxyde de terres rares, un oxyde d'un métal des groupes principaux ou un oxyde d'un métal de transition, y compris leurs oxydes binaires, ternaires ou multinaires respectifs, un zirconate, un aluminate, un titanate, un manganate, un ruthénate.

4. Agencement de couches selon la revendication 3, **caractérisé en ce que** le matériau de couche tampon recevant le constituant supplémentaire est un oxyde de terres rares binaire ou multinaire, dans lequel les composants métalliques sont partiellement ou exclusivement des métaux de terres rares, et 2 métaux de terres rares différents ou davantage sont contenus.

5. Agencement de couches selon la revendication 4, **caractérisé en ce que** le matériau de couche tampon recevant le constituant supplémentaire est un oxyde d'un métal de terres rares de formule générale RE₂₊ₓM_{2+y}O_{z} avec -2 ≤ x, y ≤ 2, RE étant un ou plusieurs métaux de terres rares et M étant un ou plusieurs métaux bi-, tri-, tétra- ou pentavalents, y compris les métaux de terres rares.

6. Agencement de couches selon l'une quelconque des revendications 1 à 5, **caractérisé en ce que** la porosité de la couche tampon contenant le constituant supplémentaire est ≤ 25 %.

7. Agencement de couches selon l'une quelconque des revendications 1 à 6, **caractérisé en ce que** la couche tampon contenant le constituant supplémentaire présente une rugosité RMS ≤ 1,8 nm.

8. Agencement de couches selon l'une quelconque des revendications 1 à 7, **caractérisé en ce que** (i) la couche tampon comprend plusieurs couches, et **en ce que** la couche tampon à phase cristalline mixte contenant le constituant supplémentaire forme une couche adjacente à la couche de supraconducteur à haute température, et/ou en ce que (ii) la couche tampon agencée entre le matériau support et la couche HTSL ne comprend que des couches qui comprennent un constituant supplémentaire formant une phase cristalline mixte homogène, et/ou **en ce que** (iii) la couche tampon n'est configurée qu'à une couche.

9. Agencement de couches selon l'une quelconque des revendications 1 à 8, **caractérisé en ce qu'**un supraconducteur à haute température est appliqué sur la couche tampon.

10. Procédé de fabrication d'un agencement de couches de supraconducteur à haute température selon l'une quelconque des revendications 1 à 9, selon lequel une couche tampon texturée est appliquée sur un matériau support, qui est texturé et qui est un métal ou un alliage, ladite couche tampon permettant une croissance texturée d'un supraconducteur à haute température, au moins un constituant supplémentaire formant une phase cristalline mixte homogène étant introduit dans le matériau de la couche tampon, ledit constituant supplémentaire contenant au moins un métal de transition, y compris sous la forme d'un oxyde, et le matériau de la couche tampon étant formé par revêtement en solution chimique et appliqué sur le matériau support, le constituant supplémentaire et le matériau de la couche tampon et/ou leurs précurseurs respectifs étant déposés séparément ou ensemble au moyen d'une solution chimique sur la sous-couche respective, et le substrat revêtu étant soumis à un traitement de recuit avec formation d'une phase cristalline mixte homogène contenant le constituant supplémentaire, éventuellement après des étapes de dépôt supplémentaires du matériau de la couche tampon et/ou du constituant supplémentaire, **caractérisé en ce que** du cuivre et/ou de l'argent sont utilisés en tant que métal de transition.

11. Procédé selon la revendication 10, **caractérisé en ce qu'**un matériau de couche tampon selon l'une quelconque des revendications 2 à 8 est appliqué et/ou en ce qu'un supraconducteur à haute température est appliqué sur la couche tampon.

12. Procédé selon l'une quelconque des revendications 10 ou 11, **caractérisé en ce que** la couche tampon est appliquée en plusieurs couches et **en ce que** la couche tampon à phase cristalline mixte contenant le constituant supplémentaire est configurée sur le matériau support et/ou en tant que couche adjacente à la couche de supraconducteur à haute température.

13. Procédé selon l'une quelconque des revendications 10 à 12, **caractérisé en ce que** la couche tampon n'est formée que par une ou plusieurs couches qui comprennent chacune un constituant supplémentaire formant une phase cristalline mixte homogène.

14. Procédé selon l'une quelconque des revendications 10 à 13, **caractérisé en ce que** les composants métalliques du matériau tampon et/ou du constituant supplémentaire (i) sont appliqués au moins en partie ou en totalité sous la forme d'alkylcarboxylates, d'acétylacétonates ou sous la forme d'autres complexes de préférence chélateurs dans un solvant organique sur le matériau support ou une couche de matériau tampon déjà présente, y compris leurs précurseurs, et/ou (ii) sont appliqués sous la forme de composés solubles dans l'eau dans une solution aqueuse sur le matériau support ou une couche de matériau tampon déjà présente, y compris leurs précurseurs.

15. Procédé selon l'une quelconque des revendications 10 à 14, **caractérisé en ce que** le traitement de recuit pour la formation de la couche tampon contenant le constituant supplémentaire a lieu au moins en partie dans une atmosphère réductrice.
